# EUROPEAN PATENT APPLICATION

(11) **EP 4 566 437 A1**
(43) Date of publication of application: **11.06.2025**
(21) Application number: 24216464.8
(22) Date of filing: 29.11.2024
(51) Int. Cl.: A01D 34/90, F21S 41/25, F21V 5/04

(54) **WORK MACHINE AND DISPLAY DEVICE**

(30) Priority: 04.12.2023 JP 2023204631
(71) Applicant: Makita Corporation, Anjo-shi Aichi 446-8502 (JP)
(72) Inventor: CHIKARAISHI, Makoto, Anjo-shi, 446-8502 (JP)
(74) Representative: Kramer Barske Schmidtchen Patentanwälte PartG mbB

(57) **Abstract**

A work machine (1, 101) includes a housing (151), a support structure (59), and a lens (51). The support structure (59) is capable of supporting, inside the housing (151), a first and a second light emitting element (57, 58) each of which emits light in a first direction. The lens (51) is configured to propagate light from a light emitting element (57, 58) supported inside the housing (151) by the support structure (59) to an outside of the housing (151). The work machine (1, 101) is configured to display information by lighting using the lens (51). The support structure (59) is capable of supporting the first and the second light emitting elements (57, 58) at respective positions where a first distance on an imaginary plane (A1) orthogonal to the first direction is different from a second distance on the imaginary plane (A1). The first distance is between a reference point (P0) and the first light emitting element (57). The second distance is between the reference point (P0) and the second light emitting element (58).

## Description

### CROSS-REFERENCE TO RELATED APPLICATIONS

This application claims the priority based on Japanese Patent Application No. 2023-204631 filed on December 4, 2023 with the Japan Patent Office, the entire disclosure of which is incorporated herein by reference.

### BACKGROUND

The present disclosure relates to a work machine and a display device.

Japanese Unexamined Patent Application Publication No. 2020-93343 discloses a technique for displaying the state of a work machine by lighting of a light emitting element. Examples of a light emitting element include a light emitting diode (LED). For displaying various types of information, for example, two or more LEDs are prepared. In one example, light from each LED propagates to the outside through an individual lens provided for each LED, and thereby a state of the work machine is displayed to a user of the work machine.

### SUMMARY

According to conventional techniques in which respective light emitting elements are provided with individual lenses, in cases where a work machine is provided with numerous light emitting elements for displaying various types of information, the work machine also needs to be provided with numerous lenses.

Preparing an individual lens for each light emitting element is inefficient. Such inefficiency may be reduced by communization of a lens among two or more light emitting elements. In one example, commonization may be achieved by arranging two or more light emitting elements for a common lens. In another example, commonization may be achieved by preparing a lens as a common component for several types of work machines and arranging different light emitting elements for the lens in accordance with the type of the work machines.

However, in communization of a lens among two or more light emitting elements, a difference in the characteristics of the light emitting elements may cause an undesirable difference in the appearance of lighting through the lens from the standpoint of displaying of information.

Thus, it is desirable in one aspect of the present disclosure to be able to provide a novel technique for arranging two or more light emitting elements in relation to a lens.

One aspect of the present disclosure provides a work machine including a housing, a support structure, and a lens. The support structure is capable of supporting, inside the housing, a first light emitting element and a second light emitting element each configured to emit light in a first direction. The lens is configured to propagate light from a light emitting element supported inside the housing by the support structure to an outside of the housing. The work machine is configured to display information by lighting using the lens.

The support structure may be capable of supporting the first light emitting element and the second light emitting element at respective positions where a first distance on an imaginary plane orthogonal to the first direction is different from a second distance on the imaginary plane. The first distance may be a distance between a reference point and the first light emitting element. The second distance may be a distance between the reference point and the second light emitting element.

The reference point may be a point out of points on the imaginary plane where, when light is emitted from the point in the first direction, a portion of the light that propagates to the outside of the housing through the lens has a highest intensity.

Even if two or more light emitting elements are arranged at respective positions where the relative positions of the respective light emitting elements to the lens are the same, the manner of lighting visually perceived by the user from the outside of the housing is different from one light emitting element to another, depending on the characteristics, such as the intensity and the wavelength, of the light emitted from the light emitting element.

According to the configuration that allows the two or more light emitting element to be supported so that their distances from the reference point are different, it is possible to arrange the respective light emitting elements relative to the lens so as to reduce the user's discomfort due to such a difference in the appearance of lighting. Thus, according to one aspect of the present disclosure, it is possible to provide a suitable technique for displaying information to the user in terms of the arrangement of the two or more light emitting elements in relation to the lens.

Another aspect of the present disclosure provides a display device including a support structure and a lens. The support structure is capable of supporting, inside the display device, a first light emitting element and a second light emitting element, the first light emitting element and the second light emitting element each being configured to emit light in a first direction. The lens is configured to propagate light from a light emitting element supported by the support structure to an outside of the display device. The display device is configured to display information by lighting using the lens.

The support structure may be capable of supporting the first light emitting element and the second light emitting element at respective positions where a first distance on an imaginary plane orthogonal to the first direction is different from a second distance on the imaginary plane. The first distance may be a distance between a reference point and the first light emitting element. The second distance may be a distance between the reference point and the second light emitting element. The reference point may be a point out of points on the imaginary plane where, when light is emitted from the point in the first direction, a portion of the light that propagates to the outside of the display device through the lens has a highest intensity.

Through this display device, it is possible to achieve the same effects as those achieved by the above-described work machine.

### BRIEF DESCRIPTION OF THE DRAWINGS

Example embodiments of the present disclosure will be described hereinafter with reference to the accompanying drawings, in which:
FIG. 1 is a block diagram showing an electrical configuration of an example work machine;
FIG. 2 is a perspective view of an example grass mower;
FIG. 3 is a top view of a vicinity of a display surface of a housing showing a display device accommodated inside the housing;
FIG. 4 is a schematic cross-sectional view of the display device accommodated inside the housing;
FIG. 5 is a perspective view of the display device;
FIG. 6A is a top view of the display device;
FIG. 6B is a side view of the display device;
FIG. 7 is a cross-sectional view of the display device cut along a line VII-VII;
FIG. 8 is a cross-sectional view of the display device cut along a line VIII-VIII;
FIG. 9 is a graph of a relative luminous efficiency in which a horizontal axis represents wavelength and a vertical axis represents relative luminous efficiency;
FIG. 10 is an illustration of an arrangement of a second LED;
FIG. 11 is an illustration of an arrangement of a first LED;
FIGS. 12A, 12B, and 12C show, in this order, simulation results for luminance distributions in situations where a lens with a 40-degree vertex angle, a lens with a 50-degree vertex angle, and a lens with a 60-degree vertex angle are respectively used;
FIGS. 13A and 13B show, in this order, simulation results for luminance distributions in situations where a lens with a 70-degree vertex angle and a lens with an 80-degree vertex angle are respectively used;
FIG. 14 is an illustration of an arrangement of the first LED and the second LED according to a variation; and
FIGS. 15A, 15B, and 15C are each an illustration of a configuration of the display device according to a variation.

### DETAILED DESCRIPTION OF EXEMPLARY EMBODIMENTS

### [1. Overview of Embodiments]

One embodiment may provide a work machine. The work machine may include at least any one of the following features:
- Feature 1: the work machine includes a housing;
- Feature 2: the work machine includes a support structure;
- Feature 3: the support structure is capable of supporting, inside the housing, a first light emitting element and a second light emitting element;
- Feature 4: the support structure is capable of supporting the first light emitting element and the second light emitting element so that the first light emitting element and the second light emitting element each emit light in a first direction;
- Feature 5: the work machine includes a lens;
- Feature 6: the lens is configured to receive light from a light emitting element supported inside the housing by the support structure;
- Feature 7: the lens is configured to propagate light from a light emitting element supported inside the housing by the support structure to an outside of the housing;
- Feature 8: the work machine is configured to display information by lighting using the lens;
- Feature 9: the support structure is capable of supporting the first light emitting element and the second light emitting element at respective positions where a first distance on an imaginary plane orthogonal to the first direction is different from a second distance on the imaginary plane, the first distance being a distance between a reference point and the first light emitting element, the second distance being a distance between the reference point and the second light emitting element; and
- Feature 10: the reference point is a point out of points on the imaginary plane where, when light is emitted from the point in the first direction, a portion of the light that propagates to the outside of the housing through the lens has a highest intensity.

Even if two or more light emitting elements are arranged so that the relative positions of the respective light emitting elements and the lens are the same, the manner of lighting visually perceived by the user from the outside the housing is different from one light emitting element to another, depending on the characteristics, such as the intensity and the wavelength, of light emitted from the light emitting element.

The work machine including Features 1 to 10 is capable of supporting two or more light emitting elements at different distances from the reference point. Thus, it is possible to arrange each light emitting element relative to the lens so as to reduce the user's discomfort due to such a difference in the appearance of lighting. In other words, it is possible according to Features 1 to 10 to arrange the two or more light emitting elements relative to the lens for suitable information display to the user.

In one embodiment, the work machine may include the following feature in addition to or in place of at least any one of Features 1 to 10:
- Feature 11: the first light emitting element and the second light emitting element are configured so that light emitted from the first light emitting element and light emitted from the second light emitting element are different from each other in at least one of wavelength or intensity.

According to the work machine including Feature 11, it is possible to arrange the two or more light emitting elements relative to the lens in consideration of at least one of the wavelength and the intensity of the light emitted from each light emitting element.

In one embodiment, the work machine may include at least any one of the following features in addition to or in place of at least any one of Features 1 to 11:
- Feature 12: the second light emitting element is configured to emit light with a wavelength with a high relative luminous efficiency as compared with light emitted by the first light emitting element;
- Feature 13: the second light emitting element is configured to emit light with a high intensity as compared with the light emitted by the first light emitting element; and
- Feature 14: the support structure is capable of supporting the first light emitting element and the second light emitting element at respective positions where a distance on the imaginary plane between the reference point and the second light emitting element is longer than a distance on the imaginary plane between the reference point and the first light emitting element.

According to the work machine including Features 12 and 14, it is possible to arrange the first light emitting element and the second light emitting element at respective positions where the difference in the relative luminous efficiencies of the light emitted from the first light emitting element and the light emitted from the second light emitting element are taken into account. According to the work machine including Features 13 and 14, it is possible to arrange the first emitting element and the second light emitting element at respective positions where the difference in the intensities of the light emitted from the first emitting element and the light emitted from the second light emitting element are taken into account.

In one embodiment, the work machine may include at least any one of the following features in addition to or in place of at least any one of Features 1 to 14:
- Feature 15: the support structure is capable of supporting the first light emitting element and the second light emitting element at respective positions where a light propagation rate of light emitted from the second light emitting element is lower than a light propagation rate of light emitted from the first light emitting element; and
- Feature 16: the light propagation rate is a proportion of, in light emitted from a corresponding light emitting element, a portion of the light that propagates to the outside of the housing through the lens.

According to the work machine including Features 15 and 16, if at least one of the relative luminous efficiency or the intensity of the light emitted from the second light emitting element is/are higher than that/those of the light emitted from the first light emitting element, it is possible to reduce the difference in the appearance of lighting and thereby reduce the user's discomfort due to the difference.

In one embodiment, the work machine may include the following feature in addition to or in place of at least any one of Features 1 to 16:
- Feature 17: the support structure is capable of supporting the first light emitting element and the second light emitting element on a plane parallel to the imaginary plane.

In one embodiment, the work machine may include the following feature in addition to or in place of at least any one of Features 1 to 17:
- Feature 18: the support structure is a circuit board that allows mounting of the first light emitting element and the second light emitting element.

According to the work machine including Feature 18, it is possible to mount the first light emitting element and the second light emitting element on the circuit board in an appropriate relative arrangement to the lens.

In one embodiment, the work machine may include the following feature in addition to or in place of at least any one of Features 1 to 18:
- Feature 19: the support structure is capable of supporting the first light emitting element at the reference point.

In one embodiment, the work machine may include at least any one of the following features in addition to or in place of at least any one of Features 1 to 19:
- Feature 20: the lens includes a light receiving surface (i) oriented toward an inside of the housing and (ii) configured to receive the light from the light emitting element supported by the support structure; and
- Feature 21: the support structure is capable of supporting the first light emitting element at a position where light emitted within an angular range from the first light emitting element is received in an entirety of the angular range on the light receiving surface, the angular range being centered on a central axis of the first light emitting element and corresponding to an irradiation angle of the first light emitting element.

According to the work machine including Feature 19 or Feature 21, it is possible to reduce loss (or attenuation) of the light of the first light emitting element, and thereby increase luminance of light output from the output surface.

In one embodiment, the work machine may include the following feature in addition to or in place of at least any one of Features 1 to 21:
- Feature 22: the support structure is capable of supporting the first light emitting element at a position where light emitted within an angular range from the first light emitting element is received in an entirety of the angular range on the light receiving surface, the angular range being a range up to 60 degrees from a central axis of the first light emitting element.

Light emitting elements with an irradiation angle of 120 degrees are widely used. According to the work machine including Feature 22, it is possible, when the popular type of a light emitting element is used as the first light emitting element, to reduce loss of light of the first light emitting element and thereby increase the luminance of the light output from the output surface.

In one embodiment, the work machine may include the following feature in addition to or in place of at least any one of Features 1 to 22:
- Feature 23: the support structure is capable of supporting the second light emitting element at a position where an angle between an imaginary straight line and the first direction is equal to or smaller than a reference angle, the imaginary straight line connecting the second light emitting element and an outer edge of the light receiving surface.

In one embodiment, the work machine may include the following feature in addition to or in place of at least any one of Features 1 to 23:
- Feature 24: the reference angle corresponds to half of an irradiation angle of the second light emitting element.

According to the work machine including Feature 23 or Feature 24, it is possible to propagate the light from the second light emitting element to the outside of the housing through the light receiving surface of the lens.

In one embodiment, the work machine may include the following feature in addition to or in place of at least any one of Features 1 to 24:
- Feature 25: the reference angle is 60 degrees.

According to the work machine including Feature 25, it is possible, when the popular type of a light emitting element having, for example, an irradiation angle of 120 degrees is used as the second light emitting element, to propagate the light from the second light emitting element to the outside of the housing through the light receiving surface of the lens.

In one embodiment, the work machine may include at least any one of the following features in addition to or in place of at least any one of Features 1 to 25:
- Feature 26: the lens has an axisymmetric shape; and
- Feature 27: the reference point is an intersection point of a central axis of the lens and the imaginary plane.

According to the work machine including Feature 26 and Feature 27, it is possible to efficiently guide light that propagates in a manner of axisymmetric expansion from a luminous point to the outside of the housing with minimal loss.

In one embodiment, the work machine may include at least any one of the following features in addition to or in place of at least any one of Features 1 to 27:
- Feature 28: lens includes, as a surface oriented toward an inside of the housing, a light receiving surface configured to receive the light from the light emitting element supported by the support structure;
- Feature 29: the lens includes, as a surface oriented toward the outside of the housing, an output surface configured to output the light from the light emitting element supported by the support structure; and
- Feature 30: the lens has a shape in which the output surface has an area larger than an area of the light receiving surface.

In one embodiment, the work machine may include at least any one of the features in addition to or in place of at least any one of Features 1 to 30:
- Feature 31: the lens has a shape of substantially a truncated cone with a bottom base and a top base with a diameter smaller than a diameter of the bottom base; and
- Feature 32: the lens is arranged so that the bottom base is oriented toward the outside of the housing and the top base is oriented toward an inside of the housing.

Light from a light emitting element propagates in a wider range as the distance from its luminous point increases. Thus, according to the work machine including Features 28 to 30 or Features 31 to 32, it is possible to efficiently guide the light from the light emitting element to the outside of the housing with minimal loss.

In one embodiment, the work machine may include the following feature in addition to or in place of at least any one of Features 1 to 32:
- Feature 33: the lens has a shape in which an angle of a side surface of the truncated cone with respect to a central axis of the truncated cone is in a range of 33 to 35 degrees.

According to the work machine including Feature 33, it is possible, when the popular type of a light emitting element is used which has an irradiation angle of, for example, 120 degrees, to efficiently guide the light from the light emitting element to the outside of the housing with minimal loss.

In one embodiment, the work machine may include at least any one of the following features in addition to or in place of at least any one of Features 1 to 33:
- Feature 34: the first light emitting element has an irradiation angle of 120 degrees; and
- Feature 35: the second light emitting element has an irradiation angle of 120 degrees.

In one embodiment, the work machine may include at least any one of the following features in addition to or in place of at least any one of Features 1 to 35:
- Feature 36: the first light emitting element is a red LED; and
- Feature 37: the second light emitting element is a green LED.

In one embodiment, the work machine may include at least any one of the following features in addition to or in place of at least any one of Features 1 to 37:
- Feature 38: the first light emitting element is a surface-mount LED; and
- Feature 39: the second light emitting element is a surface-mount LED.

In one embodiment, the work machine may include at least any one of the following features in addition to or in place of at least any one of Features 1 to 39:
- Feature 40: the first light emitting element is a surface-mount red LED; and
- Feature 41: the second light emitting element is a surface-mount green LED.

In one embodiment, Features 1 to 41 may be combined in any combinations. In one embodiment, any one of Features 1 to 41 may be excluded.

One embodiment may provide a display device. The display device may include at least any one of the following features:
- Feature 42: the display device includes a support structure;
- Feature 43: the support structure is capable of supporting, inside the display device, a first light emitting element and a second light emitting element;
- Feature 44: the support structure is capable of supporting the first light emitting element and the second light emitting element so that the first light emitting element and the second light emitting element each emit light in a first direction;
- Feature 45: the display device includes a lens;
- Feature 46: the lens is configured to receive light from a light emitting element supported inside the display device by the support structure;
- Feature 47: the lens is configured to propagate light from the light emitting element supported inside the display device by the support structure to an outside of the display device;
- Feature 48: the display device is configured to display information by lighting using the lens;
- Feature 49: the support structure is capable of supporting the first light emitting element and the second light emitting element at respective positions where a first distance on an imaginary plane orthogonal to the first direction is different from a second distance on the imaginary plane, the first distance being a distance between a reference point and the first light emitting element, the second distance being a distance between the reference point and the second light emitting element; and
- Feature 50: the reference point being a point out of points on the imaginary plane where, when light is emitted from the point in the first direction, a portion of the light that propagates to the outside of the display device through the lens has a highest intensity.

As with the work machine including Features 1 to 10, the display device including Features 42 to 50 allows the two or more light emitting elements to be arranged in relation to the lens so that a suitable appearance of displayed information is achieved.

In one embodiment, the display device may be incorporated in the work machine. In one embodiment, the display device may include at least any one of Features 11 to 41 of the work machine or equivalent features in addition to or in place of at least any one of Features 42 to 50. The equivalent features may be features that can be understood by replacing "outside of the housing" with "outside of the display device", or by replacing "inside of the housing" with "inside of the display device".

### [2. Specific Example Embodiments]

### <2.1. Overall Configuration>

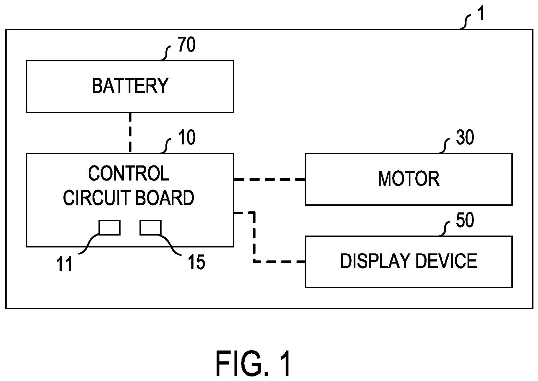

The following example embodiment provides a work machine 1 with a configuration described below. As shown in FIG. 1, the work machine 1 includes a control circuit board 10, a motor 30, a display device 50, and a battery 70. The control circuit board 10, the motor 30, and the display device 50 are configured to be operated by an electric power supplied from the battery 70.

The control circuit board 10 is configured to control the motor 30 and the display device 50. The control circuit board 10 includes a processor 11 and a memory 15. The processor 11 is configured to perform processing for controlling the motor 30 and the display device 50 in accordance with computer programs recorded in the memory 15. Examples of the memory 15 include a RAM, a ROM, and an NVRAM.

The motor 30 is controlled by the control circuit board 10 and configured to drive a work tool. In a case where the work machine 1 is a grass mower, the work tool is a cutting blade. In a case where the work machine 1 is a power cutter, the work tool is a disc blade. The work tool is rotationally driven by the motor 30, for example.

The display device 50 is configured to display the state of the work machine 1 as information. Examples of the state of the work machine 1 include an overload state of the motor 30 and a charging state of the battery 70. The work machine 1 is provided with one display device 50 or two or more display devices 50.

### <2.2. Configuration of Grass Mower>

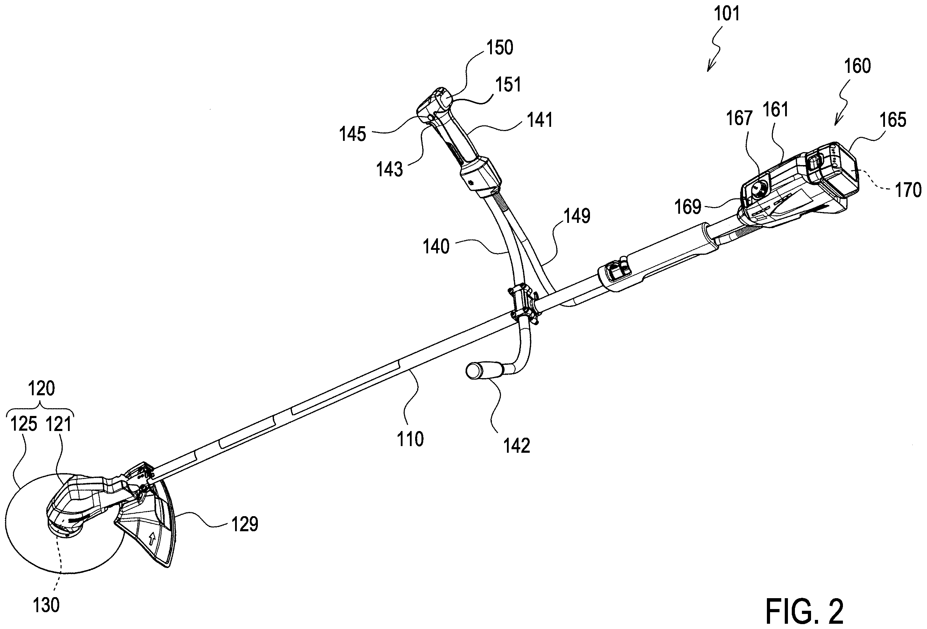

FIG. 2 shows a grass mower 101 as an example of the work machine 1. The grass mower 101 includes a main pipe 110, a drive unit 120, a handle 140, and a control unit 160.

The main pipe 110 is formed in the shape of a long and hollow bar. The drive unit 120 is arranged at the front end of the main pipe 110. The control unit 160 is arranged at the rear end of the main pipe 110. The handle 140 is arranged near the middle of the main pipe 110 in the length direction of the main pipe 110.

The drive unit 120 includes a motor housing 121 and a cutting blade 125. The cutting blade 125 is removably attached to the motor housing 121. At the front end of the main pipe 110, a cover 129 is provided for inhibiting grass and other plants mown by the cutting blade 125 from flying toward a user of the grass mower 101.

In the motor housing 121, a motor 130 is installed which is configured to rotationally drive the cutting blade 125. The cutting blade 125 rotates upon receiving a driving force from the motor 130. The motor 130 corresponds to the motor 30 of the work machine 1 shown in FIG. 1.

The handle 140 is U-shaped and coupled to the main pipe 110. The handle 140 includes, at its first end, a right grip 141 to be held by the user's right hand and, at its second end, a left grip 142 to be held by the user's left hand.

At the distal end of the right grip 141, a trigger 143 and a lock-off button 145 are provided. Furthermore, a display 150 is provided at the distal end of the right grip 141. The trigger 143 is operated by the user to instruct rotation of the cutting blade 125.

The lock-off button 145 is a button for preventing or inhibiting malfunction of the cutting blade 125. When the lock-off button 145 is not pressed, the lock-off button 145 is mechanically engaged with the trigger 143. This restricts movement of the trigger 143.

When the lock-off button 145 is in a pressed state, the lock-off button 145 is disengaged from the trigger 143. This allows the user to operate the trigger 143.

The display 150 is provided at a position visible to the user working with the grass mower 101 and is configured to display information about the state of the grass mower 101 to the user. Examples of the information about the state of the grass mower 101 include the remaining energy of a battery 170, the rotation speed of the motor 130, and the operating mode of the motor 130.

Between the lower end of the right grip 141 and the front end of the control unit 160, a control wiring pipe 149 is provided. Inside the control wiring pipe 149, a control harness (not shown) is arranged. The control harness is wiring for electrical connection between the trigger 143 and the display 150 and the control unit 160.

The control unit 160 includes a rear housing 161 and a battery pack 165. The rear housing 161 accommodates a control circuit board (not shown) for controlling the motor 130 and the display 150. This control circuit board corresponds to the control circuit board 10 of the work machine 1.

The battery pack 165 is removably attached to the rear end of the rear housing 161. The battery pack 165 contains the battery 170. The battery 170 is a rechargeable power source for supplying a DC power to each part in the rear housing 161 and to the motor 130. The battery 170 includes a lithium-ion rechargeable battery, for example. The battery 170 corresponds to the battery 70 of the work machine 1.

At the front end of the rear housing 161, a speed adjustment dial 167 and a main switch 169 are arranged in a manner operable by the user. The speed adjustment dial 167 allows the user a variable setting of the rotation speed of the motor 130. The main switch 169 is a switch to start power supply from the battery 170 to each part of the grass mower 101 to thereby cause the grass mower 101 to enter a ready-for-use state.

In a case where the configuration of the work machine 1 according to the present embodiment is applied to the grass mower 101, the display device 50 specific to the present embodiment is mounted in a central housing 151 of the grass mower 101. The central housing 151 forms the outer shape of the display 150.

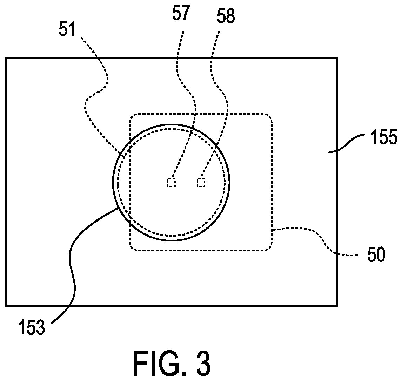

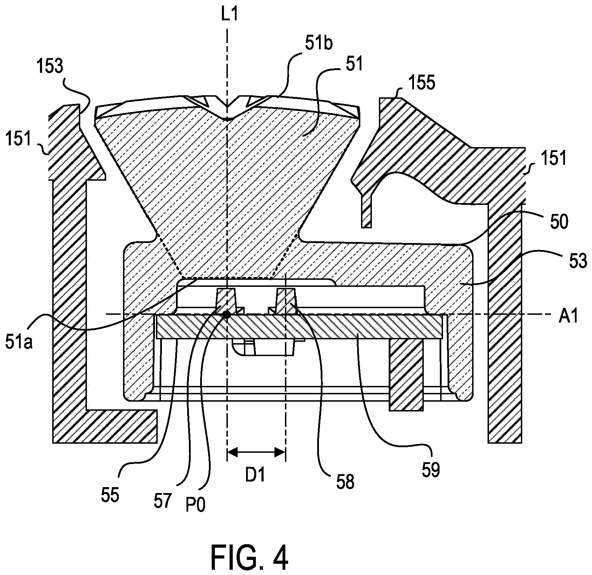

As shown in FIG. 3, the central housing 151 includes a display surface 155 with a display window 153. As shown in FIGS. 3 and 4, the display window 153 is a circular hole leading from the outside of the central housing 151 to the inside thereof. The display device 50 is accommodated in the central housing 151 so that the lens 51 is arranged in the display window 153.

FIG. 3 shows a schematic configuration around the display surface 155 viewed from a position away from the display surface 155 in the normal direction. In FIG. 3, the schematic configuration of the display device 50 arranged inside the central housing 151 is transparently shown by a broken line. FIG. 4 shows a cross-sectional configuration of the display device 50 in a plane perpendicular to the display surface 155. FIG. 3 shows an example in which the display 150 is provided with one display device 50 to simplify the description; however, the display 150 may be provided with two or more display devices 50. In addition to the display device 50 of the present embodiment which will be described in detail below, the display 150 may be provided with another type of display device(s) or other types of display devices.

### <2.3. Configuration of Display Device>

As shown in FIG. 4, the display device 50 of present embodiment includes the lens 51, a case 53, an LED circuit board 55. "LED" stands for Light Emitting Diode. The lens 51 and the case 53 are integrally molded from a transparent resin. In FIG. 4, the boundaries between the lens 51 and the case 53 are shown with broken lines. The LED circuit board 55 is positioned inside the case 53.

The case 53 is hollow-box shaped and has an inner surface defining an internal space. The LED circuit board 55 is arranged in the internal space. The case 53 is provided in the internal space with a structure that allows positioning of the LED circuit board 55. Through this structure, the LED circuit board 55 is accommodated in the case 53 so as to be positioned in relation to the lens 51.

The LED circuit board 55 includes a first LED 57, a second LED 58, a printed circuit board 59 that allows mounting of the first LED 57 and the second LED 58.

The printed circuit board 59 includes, on its surface, a pad for surface mounting of the first LED 57 at a first position and a pad for surface mounting of the second LED 58 at a second position. The printed circuit board 59 constitutes a support structure capable of supporting the first LED 57 and the second LED 58 inside the central housing 151, inside the display device 50, and inside the case 53.

According to the present embodiment, the first LED 57 is a surface-mount red LED. The second LED 58 is a surface-mount green LED. The first LED 57 may be an LED that emits red light with a wavelength of 610 to 780 nm. The second LED 58 may be an LED that emits green light with a wavelength of 500 to 570 nm.

Popular surface-mount LEDs have an irradiation angle of 120 degrees. The first LED 57 and the second LED 58 of the present embodiment are likewise surface-mount LEDs having an irradiation angle of 120 degrees. The "irradiation angle" mentioned herein corresponds to a half-power angle, which corresponds to an angular range in which the intensity of light output from the central axis of an LED decreases to 50%.

As shown in FIG. 4, the lens 51 includes, at its boundary with the case 53, a light receiving surface 51a as a surface oriented toward the inside of the display device 50 and the inside of the case 53. The light receiving surface 51a receives, inside the case 53, light emitted from the first LED 57 and light emitted from the second LED 58. The lens 51 includes, as a surface oriented toward the outside of the display device 50 and outside of the case 53, an output surface 51b that outputs the light emitted from the first LED 57 and the light emitted from the second LED 58 to the outside of the display device 50.

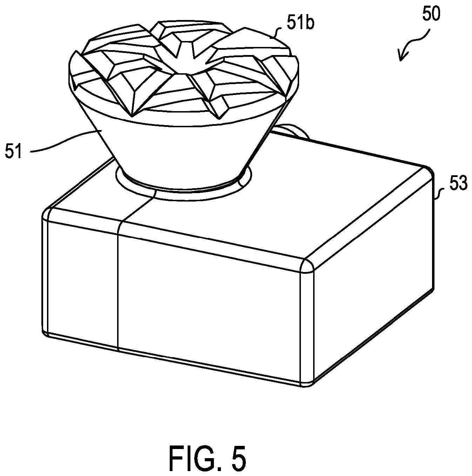

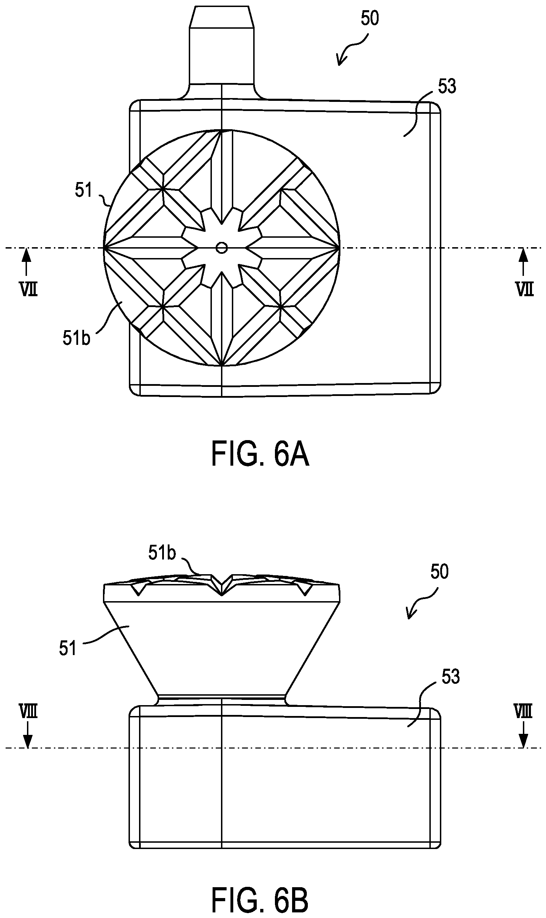

The lens 51 has an axisymmetric shape in which the area of the output surface 51b is larger than the area of the light receiving surface 51a. Specifically, as shown in FIGS. 5, 6A, and 6B, the lens 51 has the shape of substantially a truncated cone with a bottom base and a top base that is smaller in diameter than the bottom base.

The lens 51 is arranged so that the bottom base of the truncated cone is oriented toward the outside of the display device 50 and the case 53 as the output surface 51b, while the top base of the truncated cone is oriented toward the inside of the display device 50 and the case 53 as the light receiving surface 51a. As mentioned above, the boundaries between the lens 51 and the case 53 are shown in FIG. 4 with broken lines. The lens 51 has the light receiving surface 51a, which corresponds to the top base of the truncated cone, in a portion facing the internal space of the case 53. Hereinafter, the direction parallel to the central axis L1 of the lens 51 and from the light receiving surface 51a to the output surface 51b is referred to as "first direction".

As shown in FIGS. 5, 6A, and 6B, the output surface 51b is configured as a non-planar surface that is processed unevenly by geometrically providing grooves. This processing is performed for scattering light propagating from the inside of the lens 51 to the outside of the display device 50 through the output surface 51b and for improving the visibility of lighting to the user.

The LED circuit board 55 is positioned inside the case 53 of the display device 50 so that the surface of the printed circuit board 59 on which the first LED 57 and the second LED 58 are surface-mounted are oriented in the first direction, in other words, so that the normal direction of the printed circuit board 59 is parallel to the central axis of the lens 51. Thus, the first LED 57 and the second LED 58 mounted to the printed circuit board 59 are arranged inside the case 53 so that the respective central axes of the first LED 57 and the second LED 58 are each oriented in the first direction to emit light in the first direction. The first LED 57 and the second LED 58 are arranged on the same plane which corresponds to the surface of the printed circuit board 59.

According to the present embodiment, the first LED 57 is arranged at a point P0, which is the first position, at which the central axis L1 of the lens 51 and the LED circuit board 55 intersect. The point P0 is the point out of points on the surface of the LED circuit board 55 orthogonal to the first direction where, when light is emitted from the point in the first direction, a portion of the light that propagates to the outside of the display device 50 and the outside of the central housing 151 through the lens 51 has the highest intensity.

In the present embodiment, the point out of points on an imaginary plane A1 orthogonal to the first direction where, when light is emitted from the point in the first direction, a portion of the light that propagates to the outside of the display device 50 through the lens 51 has the highest intensity will be referred to as "reference point". The point P0 corresponds to the reference point. FIG. 4 shows, with a double-dashed line, the imaginary plane A1 parallel to the surface of the printed circuit board 59.

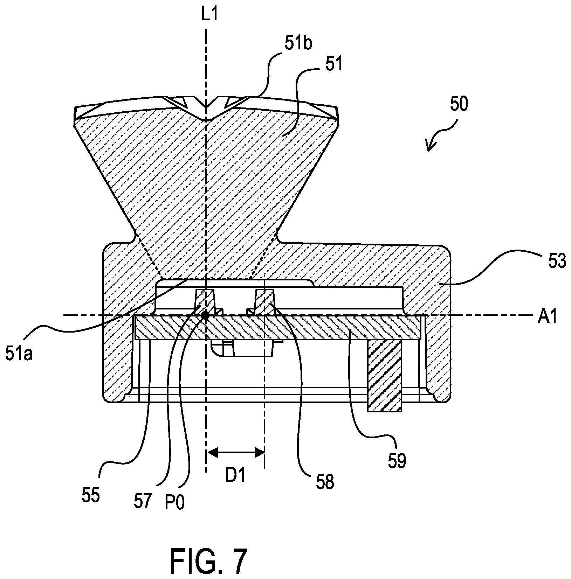

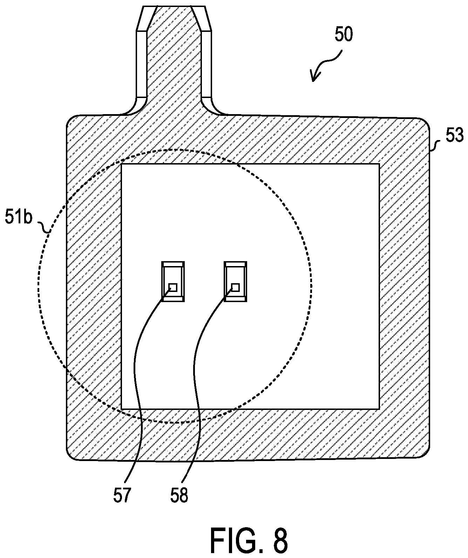

As shown in FIGS. 7 and 8, the second LED 58 is arranged at the second position which is a point on the LED circuit board 55 away from the central axis L1 of the lens 51 and the reference point. This arrangement is to reduce the propagation rate of the light emitted from the second LED 58 below the propagation rate of the light emitted from the first LED 57.

The propagation rate or light propagation rate mentioned herein corresponds to the proportion, in light emitted from a corresponding LED, of a portion of the light that propagates to the outside of the display device 50 or the central housing 151 through the lens 51. Suppressing the propagation rate enables suppressing the intensity of the portion of the light that propagates to the outside of the display device 50 and the central housing 151 through the lens 51 in the light emitted from the second LED 58. The intensity mentioned herein may be understood as the intensity per unit area, that is, luminance. Emission of light from an LED mentioned herein may be understood to mean the same as radiation or discharge of light from the LED.

The reason for positioning the second LED 58 off the central axis L1 of the lens 51 so that the light propagation rate thereof is suppressed is that the green light with a wavelength of 500 to 570 nm has a high relative luminous efficiency as compared with the red light with a wavelength of 610 to 780 nm emitted from the first LED 57.

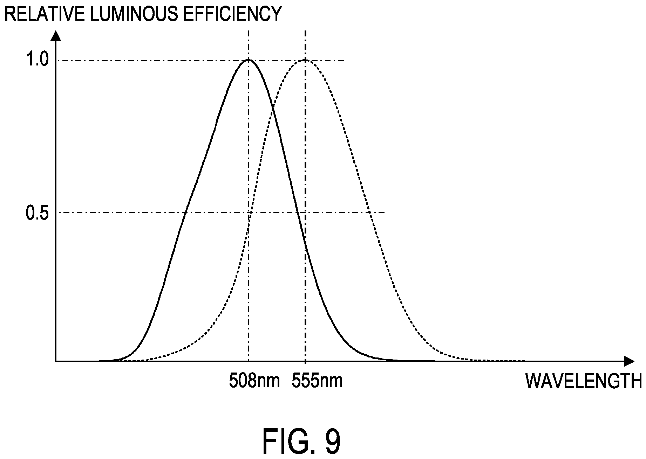

FIG. 9 shows a graph in which the horizontal axis represents wavelength and the vertical axis represents relative luminous efficiency. This graph shows a scotopic relative luminous efficiency with a solid line and a photopic relative luminous efficiency with a broken line. As can be seen from FIG. 9, both under a dim-lit condition and under a well-lit condition, the relative luminous efficiency of in a wavelength band of 610 to 780 nm which corresponds to that of red light is considerably lower than the relative luminous efficiency of a wavelength band of 500 to 570 nm which corresponds to that of green light. The relative luminous efficiency of the wavelength band of 500 to 570 nm is approximately in the range of 0.323 to 0.952, while the relative luminous efficiency of the wavelength band of 610 to 780 nm is approximately in the range of 0.000015 to 0.503.

Thus, in cases where the light emitted from a red LED and the light emitted from a green LED have approximately the same intensity, the user viewing lighting of the red LED and the green LED from the outside of the work machine 1, such as the grass mower 101, perceives the brightness of the red LED and that of the green LED differently, despite an arrangement in which the red LED and the green LED are located so that their relative positions to the lens 51 are the same. The user perceives that the green light is brighter than the red light.

Such a difference in the appearance of lighting may cause discomfort to the user and may affect visibility of displayed information. For example, the user may find information displayed in red difficult to see and information displayed in green dazzling.

In the present embodiment, to reduce such user's discomfort, the second LED 58, which emits light with a wavelength with a higher relative luminous efficiency as compared with the light emitted from the first LED 57, is positioned off the central axis L1 of the lens 51 to thereby intentionally lower the light propagation rate of the second LED 58 below that of the first LED 57.

The difference in the relative luminous efficiency between the first LED 57 and the second LED 58 is taken into consideration to determine a distance D1 from the central axis L1 of the lens 51 to the second LED 58. In cases where the intensities of the first LED 57 and the second LED 58 are not the same, the difference in the intensity is further taken into consideration to determine the distance D1.

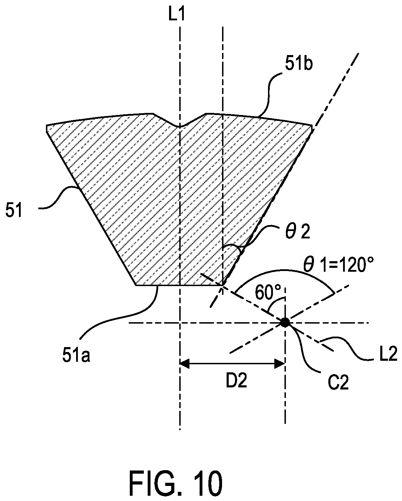

However, there is an upper limit to the distance D1 as described below. The second LED 58 is arranged on the LED circuit board 55 so that the light receiving surface 51a is positioned within an angular range centered on an axis passing through an emission center C2 of the second LED 58 and parallel to the first direction. The angular range corresponds to the irradiation angle of the second LED 58. As shown in FIG. 10, in a case where the irradiation angle of the second LED 58 is 120 degrees, the distance D1 is determined where its upper limit is a distance D2 at which light propagating from the emission center C2 of the second LED 58 in a direction inclined at 60 degrees to the first direction is incident on the outer edge of the light receiving surface 51a.

In other words, the LED circuit board 55 is configured to allow mounting of the second LED 58 at a position where the angle between an imaginary straight line L2, connecting the emission center C2 of the second LED 58 and the outer edge of the light receiving surface 51a, and the first direction is equal to or less than 60 degrees which corresponds to half of the irradiation angle. The angle half of the irradiation angle will be referred to as "reference angle".

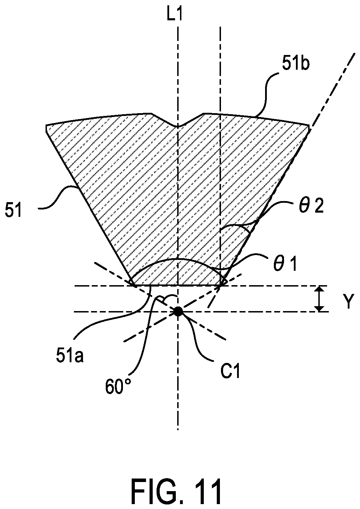

In addition, a distance Y between the light receiving surface 51a and an emission center C1 of first LED 57 in the first direction is determined to satisfy the following conditions. As shown in FIG. 11, the distance Y is determined so that the light emitted from the first LED 57 in an angular range centered on an axis passing through the emission center C1 of the first LED 57 and parallel to the first direction is received in the entirety of the angular range on the light receiving surface 51a. The angular range corresponds to an irradiation angle θ1.

Specifically, the distance Y is determined so that the light emitted from the first LED 57 in an angular range from the central axis of the first LED 57 (corresponding to the central axis L1 of the lens 51) to 60 degrees from the central axis is received in the entirety of the angular range on the light receiving surface 51a.

According to the present embodiment, the lens 51 is shaped such that an angle θ2 of the side surface of the truncated cone to the central axis L1 is in the range of 33 to 35 degrees so that the light from the first LED 57 incident on the light receiving surface 51a at the angle of 60 degrees from the central axis L1 of the lens 51 travels along the side surface of the lens 51 and efficiently propagates to the output surface 51b.

In other words, the lens 51 is shaped so that the vertex angle of a cone corresponding to the truncated cone is in the range of 66 to 70 degrees. Hereinafter, the vertex angle will be expressed as the vertex angle of the lens 51. An angle twice the angle θ2 corresponds to the vertex angle.

In cases where the lens 51 is in the shape of a truncated cone with such angles, it is possible to reduce reflection of light within the lens 51 in a process where the light discharged from the first LED 57 enters the light receiving surface 51a within the angular range, which corresponds to the irradiation angle of 120 degrees, and propagates to the output surface 51b. This reduces loss (or attenuation) of light within the lens 51 and enables output of the light with a high intensity from the output surface 51b of the lens 51.

The light incident on the light receiving surface 51a at the angle of 60 degrees from the central axis L1 of the lens 51 is refracted by the lens 51 and propagates inside the lens 51 at an angle of 33 to 35 degrees, which roughly corresponds to the angle of the side surface of the lens 51, from the central axis L1 of the lens 51.

Thus, use of the lens 51 having the aforementioned shape reduces reflection of the light incident on the light receiving surface 51a inside the lens 51 and keeps the path of the light until the light passes through the output surface 51b short. As a result, loss of light is reduced, and the luminance of the light output from the output surface 51b of the lens 51 is increased. The lens 51 may have a refractive index n of, for example, n=1.6.

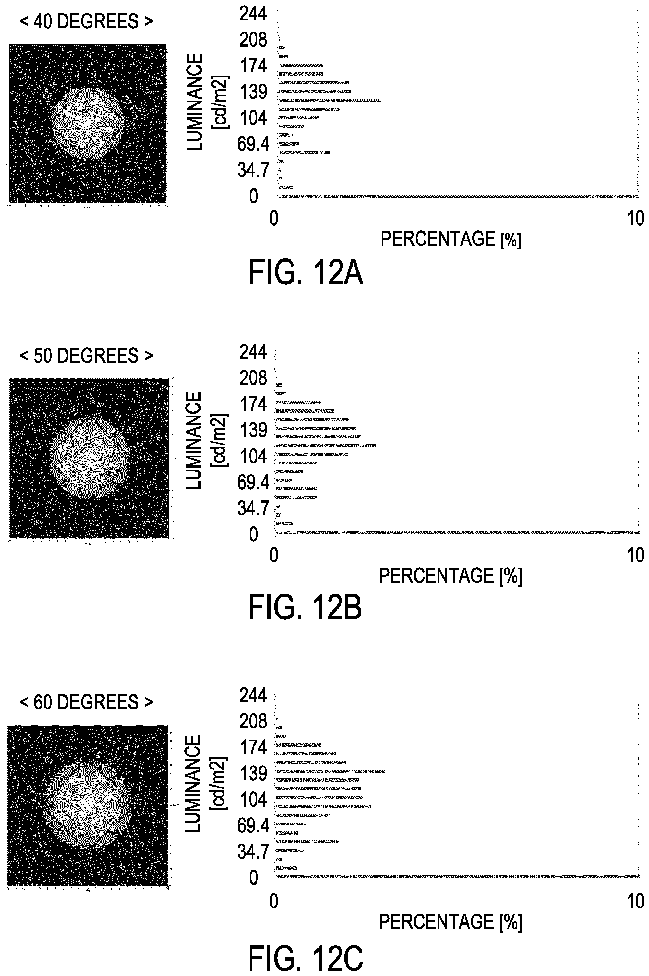

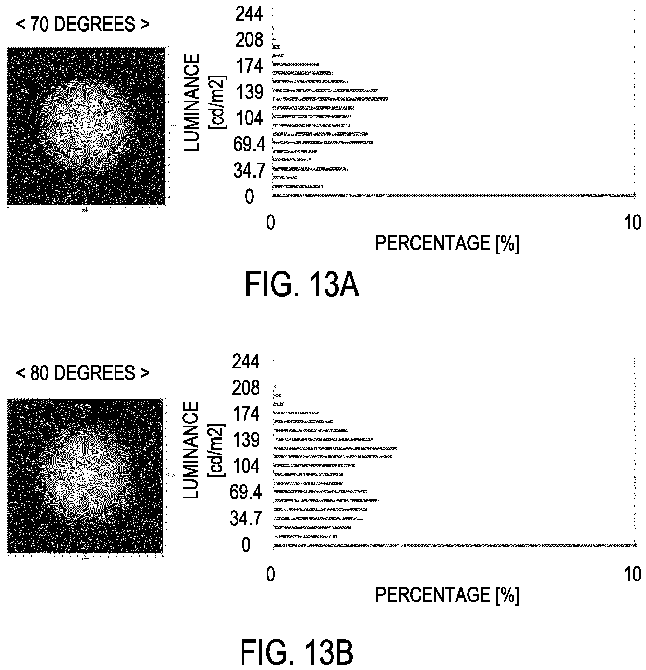

FIGS. 12A, 12B, 12C, 13A, and 13B show luminance distributions of light output from the output surface 51b of the lens 51 which are calculated through a simulation where the vertex angle of the lens 51 is set respectively to 40, 50, 60, 70, and 80 degrees, and light is emitted in the first direction from the first LED 57 which has an irradiation angle of 120 degrees and is arranged on the central axis L1 of the lens 51.

In each of FIGS. 12A, 12B, 12C, 13A, and 13B, the image on the left side represents the luminance distributions on the output surface 51b of the lens 51 in grayscale. In the image, the higher the luminance, the whiter the image is shown. The histogram on the right side represents the luminance distribution of the image on the left side using a graph in which the horizontal axis represents percentage and the vertical axis represents luminance.

FIG. 12A shows the luminance distribution when the vertex angle of the lens 51 is 40 degrees. FIG. 12B shows the luminance distribution when the vertex angle of the lens 51 is 50 degrees. FIG. 12C shows the luminance distribution when the vertex angle of the lens 51 is 60 degrees. FIG. 13A shows the luminance distribution when the vertex angle of the lens 51 is 70 degrees. FIG. 13B shows the luminance distribution when the vertex angle of the lens 51 is 80 degrees.

As can be understood from these figures, when the vertex angle of the lens 51 is 40 degrees, the output surface 51b is dark overall. When the vertex angle of the lens 51 is 50 degrees and 60 degrees, the overall luminance is higher than that when the vertex angle is 40 degrees; nevertheless, the percentages of the luminance around 70 cd/m² are lower. When the vertex angle of the lens 51 is 70 degrees, the percentages of the luminance around 70 cd/m² are greater than those when the vertex angle is 60 degrees. Thus, when the vertex angle is 70 degrees, the overall brightness of the lens 51 perceived by the user is greater than that when the vertex angle is 60 degrees. When the vertex angle of the lens 51 is 80 degrees, the average luminance of light emitting portions is decreased due to an increase in the percentages of low luminance around 30 cd/m².

The simulation results indicate that it is not preferable to use the lens 51 with a too large vertex angle or a too small vertex angle in terms of the luminance distribution. It is also supported by the simulation that it is preferable to adjust the vertex angle of the lens 51 to an angle in the range of 66 to 70 degrees, which are calculated as theoretically preferred vertex angles, or an angle around such a range. However, the vertex angle of the lens 51 may be set at an angle in a wider range of 50 to 120 degrees.

### <2.4. Effects>

The technique according to the above-described embodiment enables lighting with two or more colors through the common lens 51 and representation of several states of the work machine 1 using the single lens 51. Furthermore, commonization of components enables low-cost manufacturing of the display of the work machine 1 such as the grass mower 101 that is capable of displaying various types of information. The display device 50 of the present embodiment also helps to reduce the size of the display.

Further, it is possible in the present embodiment to arrange the red LED and the green LED in a narrow area while inhibiting the green light with a high relative luminous efficiency from being dazzling to the user and the red light with a relatively low relative luminous efficiency from being dark to the user. As a result, it is possible to configure the display device 50 and the display 150 that are compact in size and high in display capability.

### <2.5. Variations>

The above has described an example in which the display device 50 is provided in the display 150 of the grass mower 101. However, the display device 50 may be provided in the display of the work machine 1 of various types. For example, the display device 50 may be provided in the display of various types of job-site equipment including power cutters.

The display may be provided in various portions of the work machine 1 and of the grass mower 101 such as the handle, main body, and drive device thereof. In such various parts of work machines, the display device 50 may be arranged inside a housing.

The combination of the first LED 57 and the second LED 58 is not limited to a combination of a green LED and a red LED. The idea of intentionally arranging the second LED 58 off the central axis L1 of the lens 51 is useful for reducing the difference in the appearance of lighting in cases where two or more LEDs that each emit light of a wavelength with a different relative luminous efficiency and/or light with a different intensity are associated with the common lens 51.

The above-described arrangement of the first LED 57 and the second LED 58 encompasses the idea of arranging the first LED 57 and the second LED 58 at different distances from the central axis L1 of the lens 51 in a second direction parallel to the imaginary plane A1 orthogonal to the central axis L1.

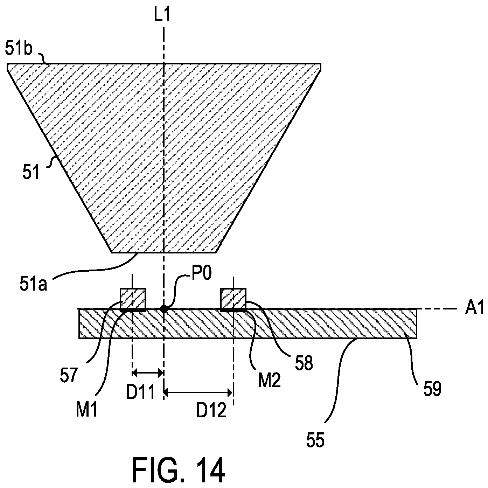

The printed circuit board 59 may be provided with a first LED mounting surface M1 (pad) and a second LED mounting surface M2 (pad) to allow mounting of the first LED 57 and the second LED 58 respectively at the first position and the second position which are located at different distances from the central axis L1 of the lens 51 (see FIG. 14).

In a case where the first position is set at a point where the distance from the central axis L1 of the lens 51 is zero, the first LED 57 is arranged at a point P0 on the central axis L1 of the lens 51, as in the example described above.

In a case where the first position is set at a point where the distance from the central axis L1 is not zero, the first LED 57 is arranged away from the central axis L1 of the lens 51. It is possible also in this case to arrange the first LED 57 and the second LED 58 on the LED circuit board 55 so that the difference in the appearance of lighting is small.

The following case will be considered where two LEDs with the same intensity but different output wavelengths are mounted on the LED circuit board 55 as the first LED 57 and the second LED 58. In this case, it is possible to mount, as the first LED 57, the LED out of the two LEDs that emits light at a wavelength with a relatively low relative luminous efficiency on the first LED mounting surface M1 of the printed circuit board 59 provided at a position near the central axis L1 of the lens 51, and mount, as the second LED 58, the other LED that emits light at a wavelength with a relatively high relative luminous efficiency on the second LED mounting surface M2 of the printed circuit board 59 provided at a position away from the central axis L1 of the lens 51.

In other words, it is possible, as shown in FIG. 14, to arrange the first LED 57, which emits light at a wavelength with a relatively low relative luminous efficiency at a distance D11 from the central axis L1 (or the reference point P0) of the lens 51 in the second direction, and arrange the second LED 58, which emits light at a wavelength with a relatively high relative luminous efficiency, at distance D12 from the central axis L1(or the reference point P0) of the lens 51 in the second direction, where the distance D12 is longer than the distance D11.

Such mounting corresponds to mounting of the LED out of the two LEDs that emits light at a wavelength with a relatively low relative luminous efficiency on the first LED mounting surface M1 where the propagation rate of light to the output surface 51b is relatively high, and of the other LED that emits light at a wavelength with a relatively high relative luminous efficiency on the second LED mounting surface M2 where the propagation rate of light to the output surface 51b is relatively low.

Similarly, in a case of two LEDs with no or a slight difference in the relative luminous efficiency but with a difference in intensity, it is possible to arrange the two LEDs on the LED circuit board 55 so that the difference in the appearance of lighting is small.

In this case, it is possible to mount, as the first LED 57, the LED out of the two LEDs that emits light with a relatively low intensity on the first LED mounting surface M1 of the printed circuit board 59 provided at a position near the central axis L1 of the lens 51, and mount, as the second LED 58, the other LED that emits light with a relatively high intensity on the second LED mounting surface M2 of the printed circuit board 59 provided at a position away from the central axis L1 of the lens 51.

Such mounting corresponds to mounting of the LED out of the two LEDs that emits light with a relatively low intensity on the first LED mounting surface M1 where the propagation rate of light to the output surface 51b is relatively high, and of the other LED that emits light with a relatively high intensity on the second LED mounting surface M2 where the propagation rate of light to the output surface 51b is relatively low.

For some types of the work machine 1, only one of the first LED 57 or the second LED 58 may be mounted. In other words, for some types of the work machine 1, an LED circuit board 551 or 552 may be prepared on which only one of the first LED 57 or the second LED 58 is mounted. The LED circuit board 551 or 552 may be arranged in the internal space of the case 53 which is a common component for two or more types of the work machine 1. The lens 51 integrated with the case 53 and the printed circuit board 59 may also be common components.

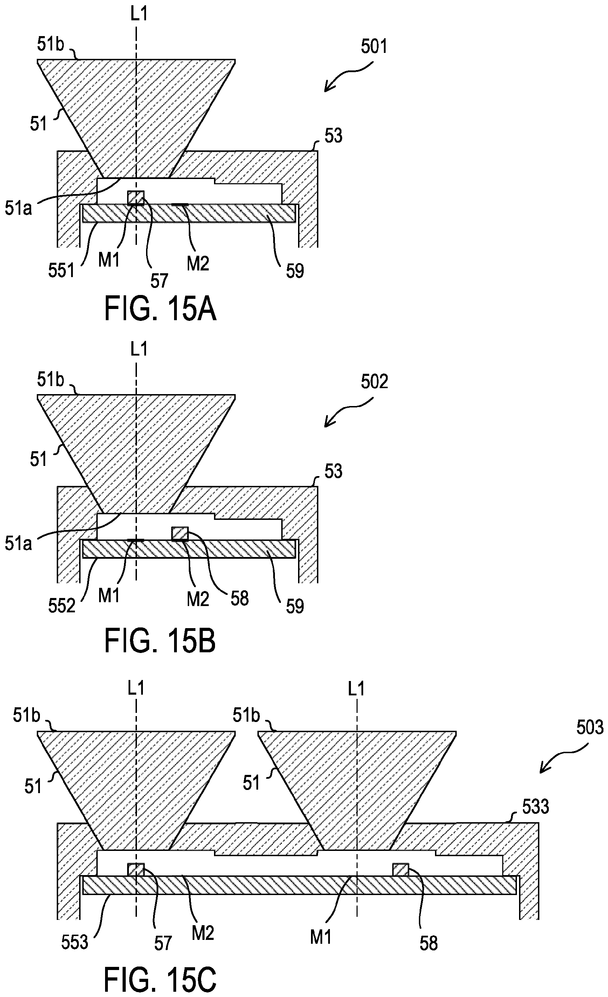

FIG. 15A shows a display device 501 according to a variation. The display device 501 includes the lens 51, the case 53, and the LED circuit board 551. In FIG. 15A, the configuration of the display device 501 is depicted in a simplified manner. In this and the following variation which will be described below, the components with the same reference numerals as those of the display device 50 of the above-described embodiment may be understood to have the same configuration as those of the display device 50. In other words, the display device 501 may be understood to have the same configuration as the above-described display device 50, except that the LED circuit board 551 has a different configuration.

FIG. 15B shows a display device 502 according to another variation. The display device 502 likewise includes the lens 51, the case 53, and the LED circuit board 552. In FIG. 15B, the configuration of the display device 502 is depicted in a simplified manner. The display device 502 may be understood to have the same configuration as the above-described display device 50, except that the LED circuit board 552 has a different configuration.

As with the LED circuit board 55, the LED circuit board 551 and the LED circuit board 552 each include the printed circuit board 59. Specifically, the printed circuit board 59 includes the first LED mounting surface M1 (pad) at the first position and the second LED mounting surface M2 (pad) at the second position.

However, the LED circuit board 551 is provided with the first LED 57 on the first LED mounting surface M1, but is not provided with the second LED 58 on the second LED mounting surface M2. The LED circuit board 552 is not provided with the first LED 57 on the first LED mounting surface M1, but is provided with the second LED 58 on the second LED mounting surface M2.

In addition, the work machine 1 may be equipped with a display device 503 that includes an LED circuit board 553 formed by integrating the LED circuit board 551 and the LED circuit board 552. The display device 503 shown in FIG. 15C includes two lenses 51, one case 533, and one LED circuit board 553. The display device 503 is different from the above-described display device 50 in that the LED circuit board 553 has a different configuration, two lenses 51 are provided, and accordingly the case 533 has a different configuration.

As can be understood from the description of the display device 503, the work machine 1 may be provided with a display device in which two or more lenses 51 are arranged in a row or in two dimensions. This display device may be configured by integrating the above-described display devices 50, 501, 502 of several types similarly to the display device 503.

### <2.6. Others>

The present disclosure is not limited to the above embodiments, but can be practiced in various modes. For example, the technique of the present disclosure may be applied to work machines in which the motor is driven by an AC power source. As mentioned above, it is possible to apply the technique of the present disclosure to various types of work machines.

Two or more functions achieved by one element of the above-described embodiments and variations may be achieved by two or more elements. One function achieved by one element may be achieved by two or more elements. Two or more functions achieved by two or more elements may be achieved by one element. One function achieved by two or more elements may be achieved by one element. A part of the configurations in the above-described embodiments and variations may be omitted. At least a part of the configurations in one of the above-described embodiments and variations may be added to or replaced with the configuration in another one of the above-described embodiments and variations. All the modes encompassed in the technical idea defined by the language of the claims are embodiments of the present disclosure.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A work machine (1, 101) comprising:
a housing (151);
a support structure (59) capable of supporting, inside the housing (151), a first light emitting element (57) and a second light emitting element (58) each configured to emit light in a first direction; and
a lens (51) configured to propagate light from a light emitting element (57, 58) supported inside the housing (151) by the support structure (59) to an outside of the housing (151),
the work machine (1, 101) being configured to display information by lighting using the lens (51),
the support structure (59) being capable of supporting the first light emitting element (57) and the second light emitting element (58) at respective positions where a first distance on an imaginary plane (A1) orthogonal to the first direction is different from a second distance on the imaginary plane (A1),
the first distance being a distance between a reference point (P0) and the first light emitting element (57),
the second distance being a distance between the reference point (P0) and the second light emitting element (58), and
the reference point (P0) being a point out of points on the imaginary plane (A1) where, when light is emitted from the point in the first direction, a portion of the light that propagates to the outside of the housing (151) through the lens (51) has a highest intensity.

2. The work machine (1, 101) according to claim 1, wherein
the first light emitting element (57) and the second light emitting element (58) are configured so that light emitted from the first light emitting element (57) and light emitted from the second light emitting element (58) are different from each other in at least one of wavelength or intensity.

3. The work machine (1, 101) according to claim 1, wherein
the second light emitting element (58) is configured to emit light with a wavelength with a high relative luminous efficiency as compared with light emitted by the first light emitting element (57), or light with a high intensity as compared with the light emitted by the first light emitting element (57), and
the support structure (59) is capable of supporting the first light emitting element (57) and the second light emitting element (58) at respective positions where the second distance is longer than the first distance.

4. The work machine (1, 101) according to claim 1, wherein
the second light emitting element (58) is configured to emit light with a wavelength with a high relative luminous efficiency as compared with light emitted by the first light emitting element (57), or light with a high intensity as compared with the light emitted by the first light emitting element (57), and
the support structure (59) is capable of supporting the first light emitting element (57) and the second light emitting element (58) at respective positions where a light propagation rate of light emitted from the second light emitting element (58) is lower than a light propagation rate of light emitted from the first light emitting element (57), the light propagation rate being a proportion of, in light emitted from a corresponding light emitting element, a portion of the light that propagates to the outside of the housing (151) through the lens (51).

5. The work machine (1, 101) according to any one of claims 1 to 4, wherein
the support structure (59) is capable of supporting the first light emitting element (57) and the second light emitting element (58) on a plane parallel to the imaginary plane (A1), or
the support structure (59) is a circuit board that allows mounting of the first light emitting element (57) and the second light emitting element (58).

6. The work machine (1, 101) according to any one of claims 1 to 5, wherein
the support structure (59) is capable of supporting the first light emitting element (57) at the reference point (P0).

7. The work machine (1, 101) according to any one of claims 1 to 6, wherein
the lens (51) includes a light receiving surface (51a) (i) oriented toward an inside of the housing (151) and (ii) configured to receive the light from the light emitting element (57, 58) supported by the support structure (59), and
the support structure (59) is capable of supporting the first light emitting element (57) at a position where light emitted within an angular range from the first light emitting element (57) is received in an entirety of the angular range on the light receiving surface (51a), the angular range being centered on a central axis (L1) of the first light emitting element (57) and corresponding to an irradiation angle of the first light emitting element (57).

8. The work machine (1, 101) according to any one of claims 1 to 6, wherein
the lens (51) includes a light receiving surface (51a) (i) oriented toward an inside of the housing (151) and (ii) configured to receive the light from the light emitting element (57, 58) supported by the support structure (59), and
the support structure (59) is capable of supporting the first light emitting element (57) at a position where light emitted within an angular range from the first light emitting element (57) is received in an entirety of the angular range on the light receiving surface (51a), the angular range being a range up to 60 degrees from a central axis (L1) of the first light emitting element (57).

9. The work machine (1, 101) according to any one of claims 1 to 6, wherein
the lens (51) includes a light receiving surface (51a) (i) oriented toward an inside of the housing (151) and (ii) configured to receive the light from the light emitting element (57, 58) supported by the support structure (59), and
the support structure (59) is capable of supporting the second light emitting element (58) at a position where an angle between an imaginary straight line and the first direction is equal to or smaller than a reference angle, the imaginary straight line connecting the second light emitting element (58) and an outer edge of the light receiving surface (51a).

10. The work machine (1, 101) according to claim 9, wherein
the reference angle corresponds to half of an irradiation angle of the second light emitting element (58), or
the reference angle is 60 degrees.

11. The work machine (1, 101) according to any one of claims 1 to 10, wherein
the lens (51) has an axisymmetric shape, and
the reference point (P0) is an intersection point of a central axis (L1) of the lens (51) and the imaginary plane (A1).

12. The work machine (1, 101) according to any one of claims 1 to 11, wherein
the lens (51) includes:
as a surface oriented toward an inside of the housing (151), a light receiving surface (51a) configured to receive the light from the light emitting element (57, 58) supported by the support structure (59); and
as a surface oriented toward the outside of the housing (151), an output surface (51b) configured to output the light from the light emitting element (57, 58) supported by the support structure (59), and
the lens (51) has a shape in which the output surface (51b) has an area larger than an area of the light receiving surface (51a).

13. The work machine (1, 101) according to any one of claims 1 to 12, wherein
the lens (51) has a shape of substantially a truncated cone with a bottom base and a top base with a diameter smaller than a diameter of the bottom base, and
the lens (51) is arranged so that the bottom base is oriented toward the outside of the housing (151) and the top base is oriented toward an inside of the housing (151).

14. The work machine (1, 101) according to claim 13, wherein
the lens (51) has a shape in which an angle of a side surface of the truncated cone with respect to a central axis (L1) of the truncated cone is in a range of 33 to 35 degrees.

15. The work machine (1, 101) according to any one of claims 1 to 13, wherein
the first light emitting element (57) is a red LED or a surface-mount red LED, and/or
the second light emitting element (58) is a green LED or a surface-mount green LED, and/or
the first light emitting element (57) and the second light emitting element (58) each have an irradiation angle of 120 degrees.
